# EUROPEAN PATENT APPLICATION

(11) **EP 3 013 039 A1**
(43) Date of publication of application: **27.04.2016**
(21) Application number: 15190274.9
(22) Date of filing: 16.10.2015
(51) Int. Cl.: H04N 5/60, H04N 21/41, H04N 21/485

(54) **USER TERMINAL APPARATUS AND CONTROL METHOD THEREOF**

(30) Priority: 22.10.2014 KR 20140143170
(71) Applicant: Samsung Electronics Co., Ltd., Gyeonggi-do 16677 (KR)
(72) Inventor: YOON, Seung-il, Gyeonggi-do (KR); KIM, Sang-jin, Gyeonggi-do (KR); NAM, Dae-hyun, Gyeonggi-do (KR); YOON, Min-kyung, Gyeonggi-do (KR); LEE, Kyung-hoon, Seoul (KR); JUNG, Kyung-hee, Gyeonggi-do (KR); YUN, Hyun-kyu, Seoul (KR); JUN, Byung-jo, Gyeonggi-do (KR)
(74) Representative: Taor, Simon Edward William

(57) **Abstract**

A user terminal apparatus (100) includes a communicator (110) configured to perform communication with a display apparatus (200), which outputs an audio signal and a video signal, an audio outputter (120) configured to include a receiver terminal, and a controller (130) configured to, in response to a receiver (300) being connected to a receiver terminal of the user terminal apparatus (100), transmit a signal indicating that the receiver (300) is connected, to the display apparatus (200) and in response to the output audio signal being received from the display apparatus (200), output the received audio signal to the receiver terminal.

## Description

Apparatuses and methods relate to a user terminal apparatus which may receive an audio signal from a display apparatus and output the audio signal, and a control method thereof.

Recently, with the development of information and communication technologies, various user terminal apparatuses for controlling a display apparatus have been introduced. Such user terminal apparatuses may be connected to a display apparatus and perform various functions in order to satisfy users' needs.

Meanwhile, a general user terminal apparatus may provide an earphone (e.g., headphone) system in order to minimize disturbance of other users while an audio is output, or to allow a user to enjoy listening to audio alone. Accordingly, the user may listen to music or broadcast programs using the earphone apparatus while carrying the user terminal apparatus.

A user may wish to listen to an audio alone when watching an image output from a TV. However, a TV may be a non-portable device, that is, a fixed display apparatus which is generally connected to a power source at home, so it is not convenient for the user to connect an earphone to the TV and use the earphone. In addition, it is difficult to watch TV far from the TV and inconvenient to move while watching the TV with earphones because of the earphone connected to the TV.

Thus, a method to allow a user to more conveniently listen to an audio output from a display apparatus using a device such as an earphone may be required.

An aspect of one or more exemplary embodiments relates to a user terminal apparatus which allows a user to receive and listen to an audio output from a display apparatus automatically by connecting a receiver, and a control method thereof.

According to an aspect of an exemplary embodiment, there is provided a control method of a user terminal apparatus including performing communication with a display apparatus that outputs an audio signal and a video signal, in response to determining that a receiver is connected to a receiver terminal of the user terminal apparatus, transmitting a signal to the display apparatus indicating that the receiver is connected, receiving an audio signal from the display apparatus, and outputting the received audio signal to the receiver terminal.

The method may further include, in response to receiving the audio signal from the display apparatus, transmitting a signal to the display apparatus for turning off an output of a speaker of the display apparatus.

The method may further include, in response to determining that the receiver is separated from the receiver terminal, transmitting a signal to the display apparatus for turning on the output of the speaker of the display apparatus.

The method may further include, in response to receiving the audio signal from the display apparatus, transmitting a signal to the display apparatus for controlling a volume of the display apparatus to a predetermined volume.

The method may further include, in response to determining that the receiver is separated from the receiver terminal, transmitting a signal to the display apparatus for adjusting the volume of the display apparatus to a volume which was set prior to the receiver being connected to the display apparatus.

The receiver may include at least one of an earphone and a headphone.

According to an aspect of another exemplary embodiment, there is provided a user terminal apparatus including a communicator configured to perform communication with a display apparatus, which is configured to output an audio signal and a video signal, an audio outputter configured to include a receiver terminal, and a controller configured to, in response to determining that a receiver is connected to the receiver terminal of the user terminal apparatus, transmit a signal to the display apparatus indicating that the receiver is connected, and in response to the receiving the audio signal from the display apparatus, output the received audio signal to the receiver terminal.

The controller may be further configured to, in response to receiving the audio signal, transmit a signal to the display apparatus for turning off the output of a speaker of the display apparatus.

The controller may be further configured to, in response to the receiver being separated from the receiver terminal, transmit a signal to the display apparatus for turning on the output of the speaker of the display apparatus.

The controller may be further configured to transmit a signal to the display apparatus for adjusting a volume of the display apparatus to a predetermined volume.

The controller may be further configured to, in response to determining that the receiver is separated from the receiver terminal, transmit a signal to the display apparatus for adjusting a volume of the display apparatus to a volume that was set prior to the receiver being connected to the display apparatus.

According to an aspect of another exemplary embodiment, there is provided a control method of a display apparatus including outputting an audio signal and a video signal, receiving a signal from a user terminal apparatus indicating that a receiver is connected to a receiver terminal of the user terminal apparatus, and transmitting the audio signal to the user terminal apparatus.

The method may further include turning off an output of a speaker of the display apparatus.

The method may further include, in response to receiving a signal indicating that the receiver is separated from the user terminal apparatus, turning on the output of the speaker of the display apparatus.

The method may further include adjusting a volume of the display apparatus to a predetermined volume.

The method may further include, in response to receiving a signal from the user terminal apparatus indicating that the receiver is separated from the user terminal apparatus, adjusting the volume of the display apparatus to a volume that was set prior to receiving the signal indicating that the receiver is connected.

According to an aspect of another exemplary embodiment, there is provided a display apparatus including an outputter configured to output an audio signal and a video signal, a communicator configured to perform communication with a user terminal apparatus, and a controller configured to, in response to receiving a signal from the user terminal apparatus indicating that a receiver is connected to a receiver terminal of the user terminal apparatus being received, transmit the audio signal to the user terminal apparatus.

The controller may be further configured to, in response to receiving the signal from the user terminal apparatus indicating that the receiver is connected to a receiver terminal of the user terminal apparatus, turn off an output of a speaker.

The controller may be further configured to, in response to receiving a signal indicating that the receiver is separated from the user terminal apparatus, turn off the output of the speaker.

According to an aspect of another exemplary embodiment, there is provided a display system including a display apparatus configured to output an audio signal and a video signal, and a user terminal apparatus configured to, in response to determining that a receiver is connected to a receiver terminal, transmit a signal to the display apparatus indicating that the receiver is connected, and in response to receiving the audio signal from the display apparatus, output the received audio signal through the receiver terminal, and the display apparatus is further configured to, in response to receiving a signal indicating that the receiver is connected to the receiver terminal of the user terminal apparatus, transmit the audio signal to the user terminal apparatus.

According to the one or more exemplary embodiments, when an earphone is connected to a user terminal apparatus, a user may listen to an audio output from a display apparatus through the earphone automatically and thus, user convenience is improved.

The above and/or other aspects of the present inventive concept will be more apparent by describing certain exemplary embodiments of the present inventive concept with reference to the accompanying drawings, in which:
FIG. 1 is a view illustrating a display system according to an exemplary embodiment;
FIG. 2A is a block diagram illustrating a configuration of a user terminal apparatus according to an exemplary embodiment;
FIG. 2B is a block diagram illustrating a configuration of a display apparatus according to an exemplary embodiment;
FIG. 3 is a view illustrating a method in which a user terminal apparatus outputs an audio automatically once an earphone is connected according to an exemplary embodiment;
FIG. 4 is a block diagram illustrating a configuration of a display system in detail according to an exemplary embodiment;
FIG. 5 is a block diagram illustrating a configuration of a user terminal apparatus according to another exemplary embodiment;
FIGS. 6A and 6B are views illustrating a method in which an output of a speaker of a display apparatus is turned off once an earphone is connected to a user terminal apparatus according to an exemplary embodiment;
FIG. 7 is a viewillustrating a method of adjusting an output volume of a display apparatus by connecting an earphone to a user terminal apparatus according to an exemplary embodiment;
FIG. 8 is a flowchart illustrating a control method of a user terminal apparatus according to an exemplary embodiment;
FIG. 9 is a flowchart illustrating a control method of a display apparatus according to an exemplary embodiment;
FIG. 10 is a flowchart illustrating a control method of a display system according to an exemplary embodiment; and
FIG. 11 is a flowchart illustrating a control method of a display system according to another exemplary embodiment.

One or more exemplary embodiments will be described in detail with reference to the accompanying drawings.

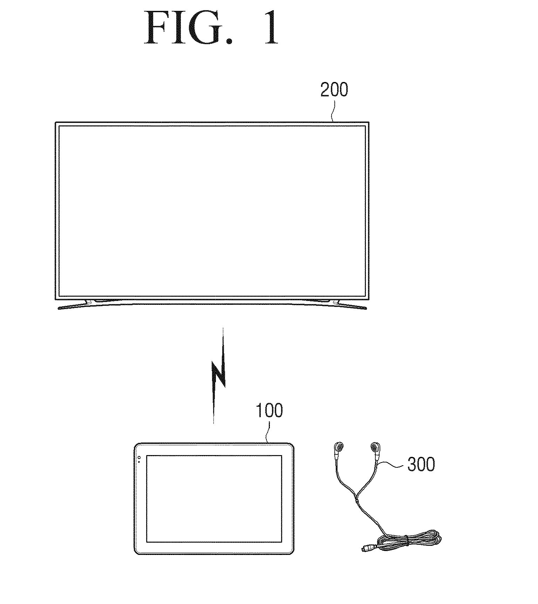

FIG. 1 is a view illustrating a display system according to an exemplary embodiment.

Referring to FIG. 1, a display system according to an exemplary embodiment includes a user terminal apparatus 100 and a display apparatus 200.

The user terminal apparatus 100 is an element to control the display apparatus 200. The user terminal apparatus 100 may be a remote control apparatus capable of communicating with the display apparatus 200. In addition, the user terminal apparatus 100 may be a portable terminal apparatus capable of performing a remote control function with respect to the display apparatus 200 when an application providing a remote control mode or a remote control function is in operation, such as a smart phone, a Personal Digital Assistant (PDA), a tablet PC, etc.

The user terminal apparatus 100 may receive a user command to control the display apparatus 200 and transmit a control signal corresponding to the input user command to the display apparatus 200. However, the functions of the user terminal apparatus 100 are not limited thereto in embodiments of the invention, and the user terminal apparatus 100 may detect a movement of the user terminal apparatus 100 and transmits a signal corresponding to the movement, recognize a voice and transmit a signal corresponding to the recognized voice, or transmit a signal corresponding to an input key, etc. In addition, even though the state of the user terminal apparatus 100 may have changed, for example, as a receiver 300 such as an earphone and a headphone is connected to a receiver terminal of the user terminal apparatus 100, the user terminal apparatus 100 may transmit a corresponding signal to the display apparatus 200.

The display apparatus 200 may be realized as a digital TV as illustrated in FIG. 1, but is not limited thereto in embodiments of the invention. The display apparatus 200 may be realized as various apparatuses with a display function, such as a Personal Computer (PC), a Navigation, a kiosk, a Digital Information Display (DID), etc.

If the display apparatus 200 is realized as a digital TV, the display apparatus 200 may be controlled by the user terminal apparatus 100. The display 200 may be connected to the user terminal apparatus 100, transmitting contents to the user terminal apparatus 100, or receiving various control signals from the user terminal apparatus 100.

In addition, the display apparatus 200 may provide a User Interface (UI) screen including a variety of information according to a user command input through the user terminal apparatus 100.

In particular, the display apparatus 200 may provide a UI screen including information regarding which mode the display apparatus 200 operates in or which function is performed according to a signal received from the user terminal apparatus 100. In addition, the display apparatus 200 may perform a function such as the function of transmitting data to the user terminal apparatus 100 based on a control signal received from the user terminal apparatus 100, or an operation mode of the display apparatus 200.

The receiver 300 is an element to convert an electrical signal to a sound signal so that a user may listen to the sound. The receiver 300 may be realized as a small-scale apparatus which can be inserted into or attached to an ear, such as an earphone and a headphone, and it may be connected to the user terminal apparatus 100.

In particular, in a case in which the user terminal apparatus 100 includes a speaker, if the receiver 300 is connected to the user terminal apparatus 100, the output of the speaker of the user terminal apparatus 100 is generally turned off, and the user terminal apparatus 100 outputs an audio signal through a receiver terminal. Accordingly, a user may listen to an audio played on the user terminal apparatus through the receiver 300 only with the operation of inserting the receiver 300 into the receiver terminal of the user terminal apparatus 100.

Once the receiver 300 is connected to the receiver terminal of the user terminal apparatus 100, the user terminal apparatus 100 may transmit a signal indicating that the receiver 300 is connected, to the display apparatus 200. Hereinafter, an exemplary embodiment will be described in detail with reference to a block diagram illustrating specific configuration of the display apparatus 200 and the user terminal apparatus 100.

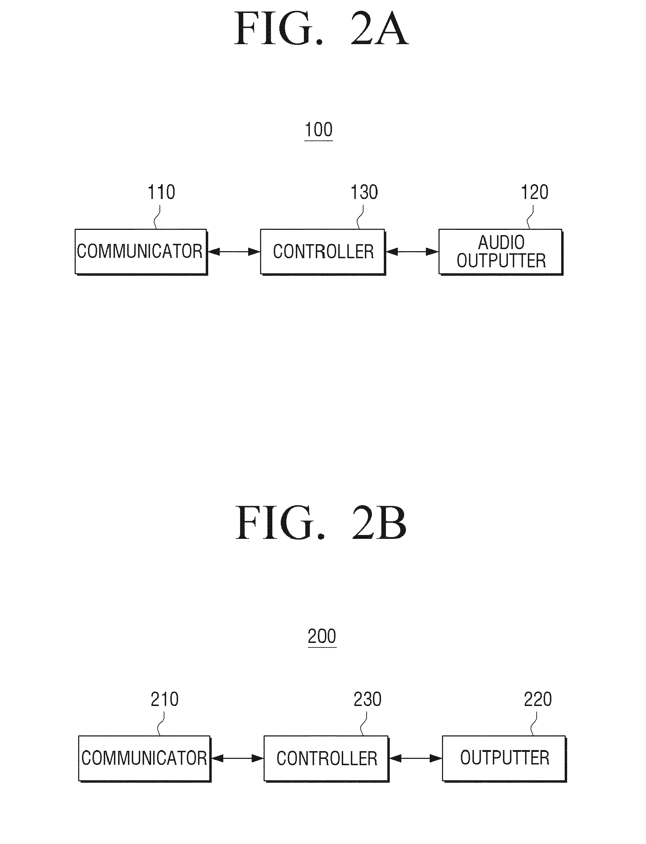

FIG. 2A is a block diagram illustrating a configuration of a user terminal apparatus according to an exemplary embodiment.

Referring to FIG. 2A, the user terminal apparatus 100 according to an exemplary embodiment includes a communicator 110, an audio output unit 120 (e.g., audio ouputter), and a controller 130.

The communicator 110 is an element which performs communication with the display apparatus 200. The communicator 110 may perform communication with the display apparatus 200 through various communication methods such as Bluetooth (BT), Wireless Fidelity (Wi-Fi), Zigbee, Infrared (IR), Near Field Communication (NFC), etc.

Specifically, if a predetermined event occurs, the communicator 110 may communicate with the display apparatus 200 according to a predetermined communication method and may be interlocked with the display apparatus 200. Herein, the state of being interlocked indicates any state in which communication is possible, such as the operation of initializing communication between the user terminal apparatus 100 and the display apparatus 200, the operation of forming a network, the operation of performing apparatus pairing, etc. For example, the apparatus identification information of the user terminal apparatus 100 may be provided to the display apparatus 200 and, accordingly, pairing between the two apparatuses may be performed. For example, if a predetermined event occurs in the user terminal apparatus 100, a peripheral apparatus may be searched through a Digital Living Network Alliance (DLNA) technology and pairing with the searched apparatus may be performed. Accordingly, the two apparatuses may be interlocked with each other.

The predetermined event may occur in at least one of the user terminal apparatus 100 and the display apparatus 200. For example, a user command to select the display apparatus 200 as an apparatus to be controlled may be input in the user terminal apparatus 100, or the power of the display apparatus 200 may be turned on. In addition, the user terminal apparatus 100 may be interlocked with the display apparatus 200 automatically as the receiver 300 is connected to the receiver terminal of the user terminal apparatus 100.

In addition, in a case in which the user terminal apparatus 100 is interlocked with the display apparatus 200, if the receiver 300 is connected to the receiver terminal of the user terminal apparatus 100, the communicator 110 may transmit a signal indicating that the receiver 300 is connected, to the display apparatus 200. In addition, if the display apparatus 200 is outputting an audio signal, the communicator 110 may receive an audio signal from the display apparatus 200. In this case, the communicator 110 may receive an audio signal using a method of communication via Wi-Fi. In order to perform communication via Wi-Fi, both the user terminal apparatus 100 and the display apparatus 200 may have a Wi-Fi communication module.

If an audio signal is received from the display apparatus 200, the communicator 110 may transmit a signal for turning off the output of a speaker of the display apparatus 200 or a signal for controlling an output volume to a predetermined volume to the display apparatus 200.

The audio output unit 120 may be an element to output an audio signal. The audio output unit 120 includes a receiver terminal, and may further include a speaker. The receiver terminal is an element to insert the receiver 300, and once the receiver 300 is inserted into the receiver terminal, an audio signal is output to the receiver terminal and the output audio signal may be converted to a sound signal through the receiver 300.

The controller 130 may be an element to control general operations of the user terminal apparatus 100.

In particular, the controller 130 detects and determines whether the receiver 300 is connected to the receiver terminal, and if the receiver 300 is connected, may control the communicator 110 to transmit a signal indicating that the receiver 300 is connected, to the display apparatus 200. Consequently, if an audio signal output from the display apparatus 200 is received through the communicator 110, the controller 130 may output the received audio signal to the receiver terminal. In this case, the controller 130 may output the received audio signal to the receiver terminal and at the same time, may control the communicator to output a mute signal for turning off the output of the speaker of the display apparatus 200, to the display apparatus 200. Herein, the mute signal may refer to a signal for adjusting the output volume of a speaker of the display apparatus 200 to 'o' or a signal for controlling the display apparatus 200 to perform a mute function.

In addition, if the receiver 300 is separated from the receiver terminal, the controller 130 may transmit a mute release signal (e.g., unmute signal) for turning on the output of the speaker of the display apparatus 200, to the display apparatus 200. Herein, the mute release signal may refer to a signal for adjusting the output volume of a speaker of the display apparatus 200 to the previous volume which was set prior to the receiver 300 or a signal for controlling the display apparatus 200 to release the mute function.

If an audio signal output from the display apparatus 200 is received, the controller 130 may control the audio outputter to output the received audio signal to the receiver terminal and at the same time, may control the communicator to transmit a volume control signal for controlling the output volume of the display apparatus 200 to a predetermined volume to the display apparatus 200.

For example, assume that the volume of an audio signal currently output from the display apparatus 200 is "10". If a user wishes to listen to an audio by connecting the receiver 300 to the user terminal apparatus 100 and adjust the volume of the audio signal output from the display apparatus 200 so as not to interfere with the listening, the user may preset the output volume of the display apparatus 200 to be "5" when an audio is listened to through the receiver 300. Accordingly, whenever the user listens to an audio by connecting the receiver 300 to the user terminal apparatus 100, the output volume of the display apparatus 200 may be automatically adjusted to "5," which is a preset volume. Herein, the output volume of the display apparatus 200 may be set to be output consistently without any change in the volume.

If the receiver 300 is then separated from the receiver terminal, the controller 130 may control the communicator 110 to transmit a signal for controlling the speaker output volume of the display apparatus 200 to the previous volume which was set prior to the receiver being connected to the display apparatus 200 so that a user may listen to an audio directly through the display apparatus 200 when the receiver 300 is separated.

Accordingly, a user may control the display apparatus 200 automatically through an operation of connecting or separating a receiver to and from the user terminal apparatus 100 which performs communication with the display apparatus 200.

FIG. 2B is a block diagram illustrating a configuration of a display apparatus according to an exemplary embodiment.

Referring to FIG. 2B, the display apparatus 200 according to an exemplary embodiment includes a communicator 210, an output unit 220 (e.g., outputter), and a controller 230.

The communicator 210 may be an element which performs communication with the user terminal apparatus 100. The communicator 210 may perform communication with the user terminal apparatus 100 according to a predefined communication method and may be interlocked with the user terminal apparatus 100. If the receiver 300 is connected to the user terminal apparatus 100, the communicator 210 may receive a receiver connection signal indicating that the receiver 300 is connected, from the user terminal apparatus 100. In this case, if the receiver connection signal is received, the display apparatus 200 may transmit an audio signal which corresponds to an image currently played on the display apparatus to the user terminal apparatus 100. In this case, the communicator 210 may transmit the audio signal using a method of communication via Wi-Fi.

The output unit 220 is an element that outputs a video signal and an audio signal. The output unit 220 may include a display for outputting a video signal and an audio output unit for outputting an audio signal. The display unit may be realized as Liquid Crystal Display (LCD), Organic Light Emitting Diodes (OLED) display, etc. The audio output unit may be realized as a speaker, and may include a receiver terminal for connecting an earphone, a headphone, an external speaker, etc.

The controller 230 is an element to control general overall operations of the display apparatus 200.

In particular, if a signal indicating that the receiver 300 is connected to the receiver terminal of the user terminal apparatus 100 is received from the user terminal apparatus 100, the controller 230 may transmit an audio signal output from the output unit 220 to the user terminal apparatus 100. Subsequently, the controller 230 may turn off the output of the speaker of the output unit 220. Specifically, the controller 230 may perform a mute function by adjusting the output volume to "o" by changing the adjustable resistance of the speaker, or by cutting off electric current using a switch.

In addition, if a receiver disconnection signal indicating that the receiver 300 is separated from the user terminal apparatus 100 is received, the controller 230 may turn on the output of the speaker of the output unit 220 again. Specifically, the controller 230 may release the mute function by adjusting the volume to the previous volume which was set prior to the receiver 300 being connected or by restoring the electric current using the switch.

Meanwhile, if an audio signal output from the output unit 220 is transmitted to the user terminal apparatus 100, the controller 230 may adjust the speaker output volume of the output unit 220 to a predetermined volume. In addition, if a receiver disconnection signal indicating that the receiver 300 is separated from the user terminal apparatus 100 is received, the controller 230 may adjust the speaker output volume to the previous volume which was set prior to the receiver 300 being connected.

As described above, according to one or more exemplary embodiments, a user may individually listen to an audio of an image displayed on a display apparatus quickly and conveniently.

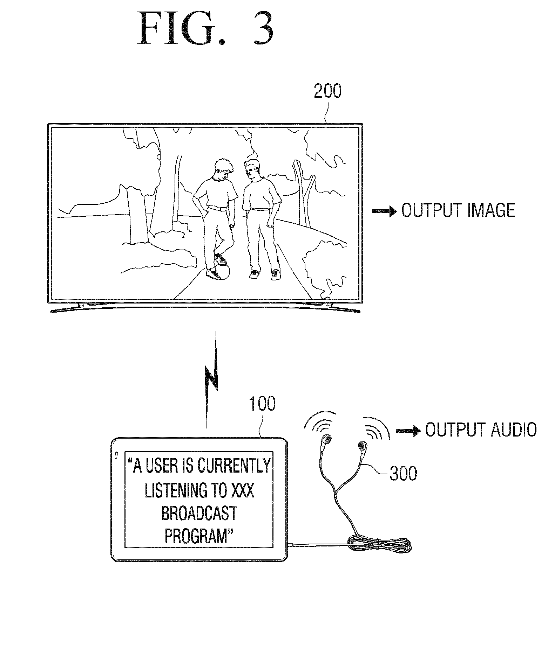

FIG. 3 is a view illustrating a method in which a user terminal apparatus outputs an audio automatically once an earphone is connected according to an exemplary embodiment.

The display apparatus 200 generally includes a tuner, and may receive a video and an audio from a broadcasting station and reproduce the received video/audio, or may include a storage and display an image stored in the storage. In this case, a user may watch an image displayed through the display apparatus 200 and listen to a voice corresponding to the displayed image alone through a receiver such as an earphone. The user may control the display apparatus 200 using the user terminal apparatus 100 which communicates with the display apparatus, and listen to the corresponding voice through the user terminal apparatus 100.

For example, as illustrated in FIG. 3, if a user connects an earphone to a receiver terminal of the user terminal apparatus 100 which is paired with the display apparatus 200, the user terminal apparatus 100 transmits a receiver connection signal to the display apparatus 200. When the display apparatus 200 receives the receiver connection signal, an audio signal currently output from the display apparatus 200 is transmitted to the user terminal apparatus 100, and the output of the speaker of the display apparatus 200 may be turned off. When the user terminal apparatus 100 receives the audio signal, the received audio signal is output through the receiver terminal.

In this case, the user terminal apparatus 100 may display information regarding the display apparatus 200 (model name, identification number, etc.) that is currently connected to a display screen. The user terminal apparatus 100 may output a message, for example, "a user is currently listening to XXX broadcast program", to let the user know which broadcast program that the user is currently listening to. Further, information regarding an audio (story, the remaining play time, etc.) which a user is currently listening to may be displayed through an external server or the Internet, and a video signal regarding an audio currently displayed on the display apparatus 200 may also be displayed so that an operation such as mirroring can be performed.

In this case, the display apparatus 200 may output a message, for example, "the current mode is an earphone connection mode" on the display screen in order to indicate that the audio output mode has been changed.

Accordingly, the user may turn off the output of the speaker of the display apparatus 200, and listen to an audio corresponding to an image output from the display apparatus 200 through an earphone connected to the user terminal apparatus 100.

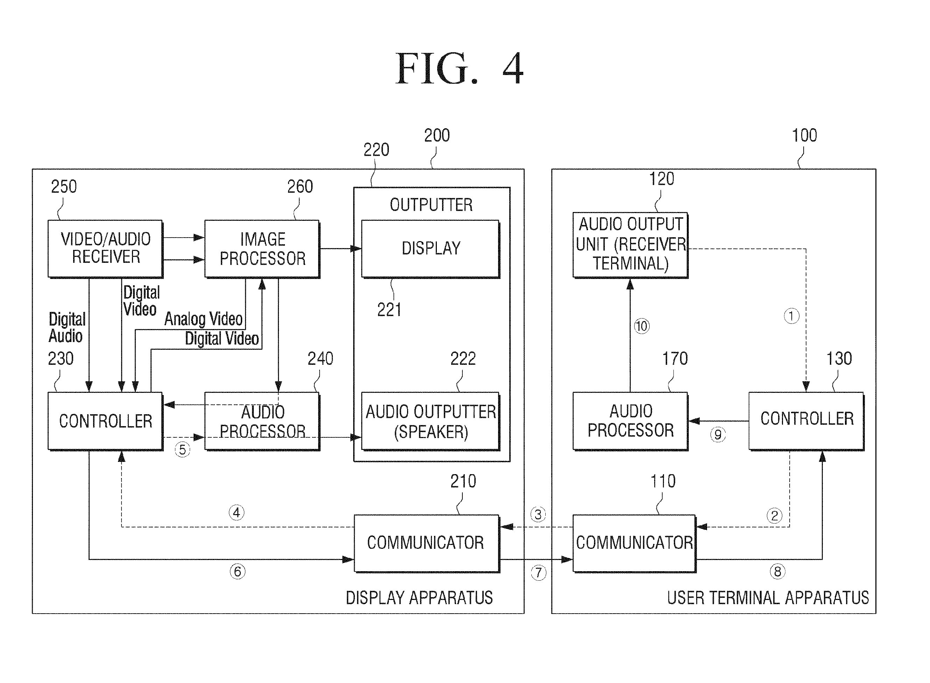

FIG. 4 is a block diagram illustrating a configuration of a display system in detail according to an exemplary embodiment. As illustrated in FIG. 4, the user terminal apparatus 100 may include the communicator 110, the audio output unit 120, an audio processor 170, and the controller 130. The display apparatus 200 may include the communicator 210, the output unit 220, which may include a display 221 and audio output unit (e.g., speaker) 222, a controller 230, an audio processor 240, an video/audio receiver 250, and an image processor 260.

If the receiver 300 is connected to a receiver terminal included in the audio output unit 120 of the user terminal apparatus 100, a receiver connection signal indicating that the receiver 300 is connected is transmitted to the controller 130 (①). The controller 130 controls the communicator 110 to process the receiver connection signal and transmit the signal to the display apparatus 200 (②③). The display apparatus 200 receives the receiver connection signal through the communicator 210, processes the signal and transmits the signal to the controller 230 (④). The controller 230 determines whether there is an audio signal currently output from the output unit, and if there is an audio signal, controls to turn off the output of an audio output unit 222 (⑤).

The video/audio receiver 250 may receive a broadcast corresponding to each broadcast channel from a broadcasting station. In this case, the image data of the received broadcast goes through the image processor 260. If an analog broadcast is received, the broadcast goes through the image processor 260 to be converted to digital image data, and if analog audio data is received, the data goes through the audio processor 240 to be converted to a digital audio signal. If a digital broadcast is received, a digital audio signal included in the digital broadcast is transmitted to the communicator 210 without going through the audio processor 240 (⑥). The communicator 210 transmits the audio signal to the user terminal apparatus 100 (⑦).

The communicator 110 of the user terminal apparatus 100 receives the audio signal and transmits the signal to the controller (⑧). The controller 130 transmits the audio signal to the audio processor (⑨), and the audio processor 170 processes the audio signal, and outputs the processed audio signal to the receiver terminal through the audio output unit 120 (⑩).

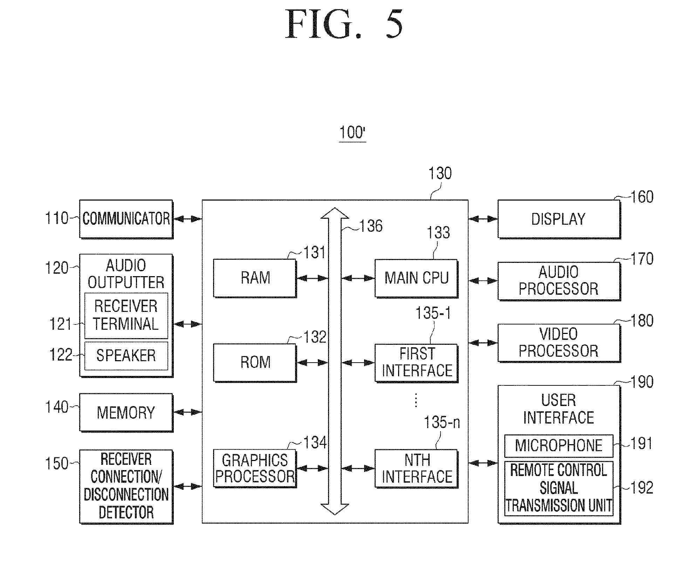

FIG. 5 is a block diagram illustrating a configuration of a user terminal apparatus according to another exemplary embodiment. As illustrated in FIG. 5, a user terminal apparatus 100' according to another exemplary embodiment may include the communicator 110, the audio output unit 120, the controller 130, a storage, a receiver connection/disconnection detector 150, a display 160, the audio processor 170, a video processor 180, and a user interface unit 190. The description regarding the elements which have already been described above with reference to FIGS. 2 to 4 will be omitted.

The communicator 110 communicates with the display apparatus 200 according to various types of communication methods. The communicator 110 may transmit various signals to control the display apparatus 200 by performing communication with the display apparatus 200, and may receive an audio signal output from the display apparatus 200, from the display apparatus 200. The communicator 110 may include various chips including a WiFi chip, a Bluetooth chip, an NFC chip, a wireless communication chip, etc. Herein, the WiFi chip, the Bluetooth chip, and the NFC chip perform communication according to a WiFi method, a Bluetooth method and an NFC method, respectively. The NFC chip represents a chip which operates according to an NFC method which uses 13.56MHz band among various RF-ID frequency bands such as 135kHz, 13.56MHz, 433MHz, 860~960MHz, 2.45GHz, and so on. In the case of the WiFi chip or the Bluetooth chip, various connection information such as SSID and a session key may be transmitted/received first for communication connection and then, various information may be transmitted/received. The wireless communication chip represents a chip which performs communication according to various communication standards such as IEEE, Zigbee, 3rd Generation (3G), 3rd Generation Partnership Project (3GPP), Long Term Evolution (LTE) and so on.

The audio output unit 120 outputs the sound of a content which is played on the user terminal apparatus 100'. The audio output unit 120 may include a receiver terminal 121 to connect the receiver 300 and a speaker 122, and may output an audio signal received from the display apparatus 200 through the receiver terminal 121.

The controller 130 controls general overall operations of the user terminal apparatus 100' using various modules stored in the storage (e.g., memory) 140.

As illustrated in FIG. 5, the controller 130 may include a RAM 131, a ROM 132, a main CPU 133, a graphics processor 134, a first to an nth interface 135-1~135-n, and a bus 136. In this case, the RAM 131, the ROM 132, the main CPU 133, the graphic processor 134, the first to the nth interface 135-1~135-n, etc. may be interconnected through the bus 136.

The ROM 132 may store a set of commands for system booting. The main CPU 133 may copy various application programs stored in the storage 120 in the RAM 131, and may perform various operations by executing application programs copied in the RAM 131.

The graphics processor 134 generates a screen including various objects such as an icon, an image, a text, etc. using a computing unit and a rendering unit. The computing unit may compute property values such as coordinates, shape, size, and color of each object to be displayed according to the layout of the screen. The rendering unit may generate a screen with various layouts including objects based on the property values computed by the computing unit.

The main CPU 133 accesses the storage 140, and performs booting using the O/S stored in the storage 140. The main CPU 133 performs various operations using various programs, contents, data, etc. stored in the storage 140.

The first to the nth interface 135-1~135-n are connected to the above-described various elements. One of the interfaces may be a network interface which is connected to an external apparatus via a network.

The storage 140 may store various modules to drive the user terminal apparatus 100'. The storage 140 may store software including various modules such as a base module, a communication module, a service module, a receiver connection/disconnection detecting module, etc.

The base module may refer to a basic module which processes a signal transmitted from each hardware included in the user terminal apparatus 100', and transmits the processed signal to an upper layer module. The base module may include a storage module, a security module, and a network module, etc. The storage module is a program module which manages a database (DB) or registry. The security module is a program module which supports certification, permission, secure storage, etc., with respect to hardware, and the network module is a module to support network connection and includes a DNET module, a UPnP module, etc.

The communication module is a module to perform communication with external apparatuses. The communication module may include a messaging module and a telephone module.

The service module includes various applications to provide various services.

The receiver connection/disconnection module determines whether a receiver is connected/disconnected to/from the user terminal apparatus 100', and receives an audio signal output from the display apparatus 200, or controls the output of the speaker of the receiver accordingly.

The receiver connection/disconnection detector 150 may detect the connection or disconnection of the receiver using the receiver connection/disconnection module stored in the storage 140.

If an audio signal received from the display apparatus 200 is currently output in the user terminal apparatus 100' through a receiver terminal, the display 160 may display information regarding the display apparatus 200 which is currently connected (model name, identification number, etc.) or information regarding a broadcast which is currently listened to. If a receiver is connected or disconnected, information thereof may be displayed. For example, if a receiver is connected, a message, "the receiver is connected", may be output, and if a receiver is disconnected, a message, "the receiver is disconnected", may be output.

The audio processor 170 processes an audio signal received from the display apparatus 200, and may perform various processing such as decoding, amplification, noise filtering, etc. with respect to an audio signal.

The video processor 180 processes a content to be displayed through the display 160. The video processor 180 may perform various image processing such as decoding, scaling, noise filtering, frame rate conversion, resolution conversion, etc. with respect to a content.

The user interface 190 may detect a user interaction to control overall operations of the user terminal apparatus 100'. In particular, as illustrated in FIG. 5, the user interface 190 may include various interaction detectors such as a microphone 191 and a remote control signal transmission unit 192. The remote control signal transmission unit 192 is an element to transmit a general control signal (power, channel control, volume control, etc.) to control the display apparatus 200.

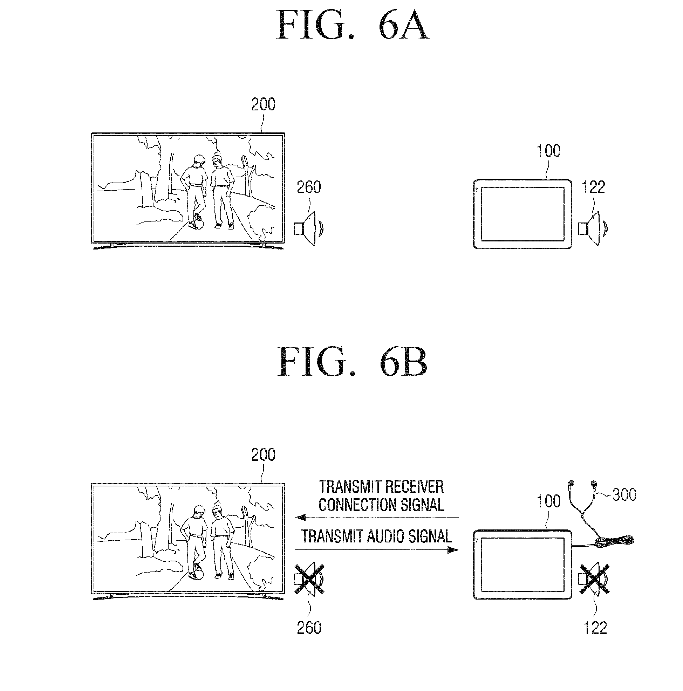

FIGS. 6A and 6B are views illustrating a method in which the output of a speaker of a display apparatus is turned off once an earphone is connected to a user terminal apparatus according to an exemplary embodiment.

Referring to FIG. 6A, the display apparatus 200 generally includes a speaker 260 therein and thus, the audio of an image currently displayed may be output through the built-in speaker 260. The user terminal apparatus 100 is a portable apparatus and generally includes a receiver terminal through which an audio is output. However, the user terminal apparatus 100 may additionally include a speaker 122 which outputs an audio without a receiver such as an earphone. Hereinafter, an example in which the user terminal apparatus 100 includes the speaker 122 will be described with reference to FIGS. 6A and 6B.

If the earphone 300 is connected to a receiver terminal of the user terminal apparatus 100, the user terminal apparatus 100 transmits a receiver connection signal indicating that the earphone is connected, to the display apparatus 200, which is in communication with the user terminal apparatus 100. If the display apparatus 200 receives the receiver connection signal, whether there is an audio signal currently output from the display apparatus 200 is determined, and an audio signal which is currently output is transmitted to the user terminal apparatus 100. In this case, the display apparatus 200 may control the display apparatus not to output an audio by turning off the output of the speaker 260 of the display apparatus 200. The user terminal apparatus 100, which receives an audio signal, may output the received audio signal through the receiver terminal, and the receiver 300 may convert the electric signal of the audio into a sound signal and output the sound. The output of the speaker 122 of the user terminal apparatus 100 may also be turned off.

Meanwhile, even if a broadcast channel which is currently output from the display apparatus 200 changes, an audio signal currently output from the display apparatus 200 is transmitted to the user terminal apparatus 100 and thus, a user may listen to an audio corresponding to an image which the user is currently watching through the receiver 300 regardless of the changing of channels.

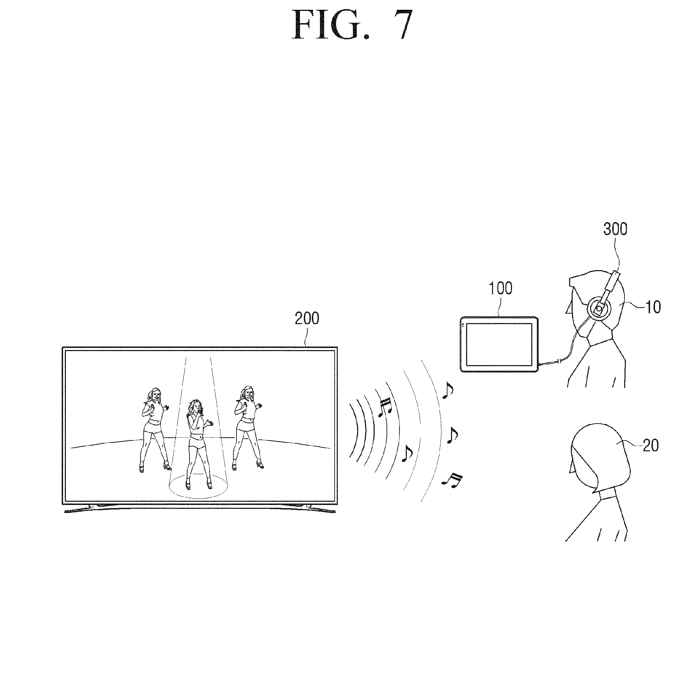

FIG. 7 is a view illustrating a method of adjusting an output volume of a display apparatus by connecting an earphone to a user terminal apparatus according to an exemplary embodiment.

As illustrated in FIG. 7, an image played in the display apparatus 200 may be watched by a plurality of users 10, 20. In this case, user 1 (10) may listen to the audio of the image at a desired volume without interfering with another user 2 (20).

For example, assume that the output volume of the display apparatus 200 is currently "10", and user 1 (10) wishes to increase the volume while user 2 (20) wishes to maintain the volume as it is or even decrease the volume. In this case, if user 1 (10) connects a receiver to the user terminal apparatus 100 which communicates with the display apparatus 200, the user terminal apparatus 100 may transmit a receiver connection signal to the display apparatus 200, and the display apparatus 200 may transmit an audio signal which is currently output, to the user terminal apparatus 100. In this case, the display apparatus 200 may maintain the current volume as it is or may decrease the volume to a predetermined volume.

Accordingly, user 1 (10) may listen to the audio output from the display apparatus 200 through the receiver 300 which is connected to the user terminal apparatus 100, and the volume of the audio may be adjusted through a volume controller within the user terminal apparatus 100. As a result, user 1 (10) may listen to the audio of an image currently output from the display apparatus 200 at a desired volume without interfering with user 2 (20).

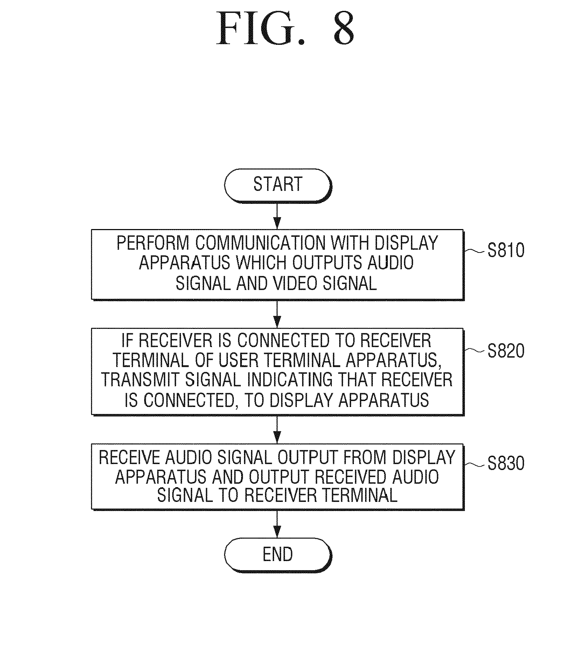

FIG. 8 is a flowchart illustrating a control method of a user terminal apparatus according to an exemplary embodiment.

First of all, communication is performed with a display apparatus which outputs an audio signal and a video signal (S81o). Subsequently, if a receiver is connected to a receiver terminal of the user terminal apparatus, a signal indicating that the receiver is connected is transmitted to the display apparatus (S820). An audio signal output from the display apparatus is received, and the received audio signal is output to the receiver terminal (S830). In this case, the user terminal apparatus may transmit a signal for turning off the output of the speaker of the display apparatus or a signal for controlling the output volume to a predetermined volume may be transmitted to the display apparatus. If the receiver is disconnected from the user terminal apparatus, a signal for turning on the output of the speaker of the display apparatus or a signal for adjusting the volume to a volume which was set prior the receiver being connected may be transmitted to the display apparatus.

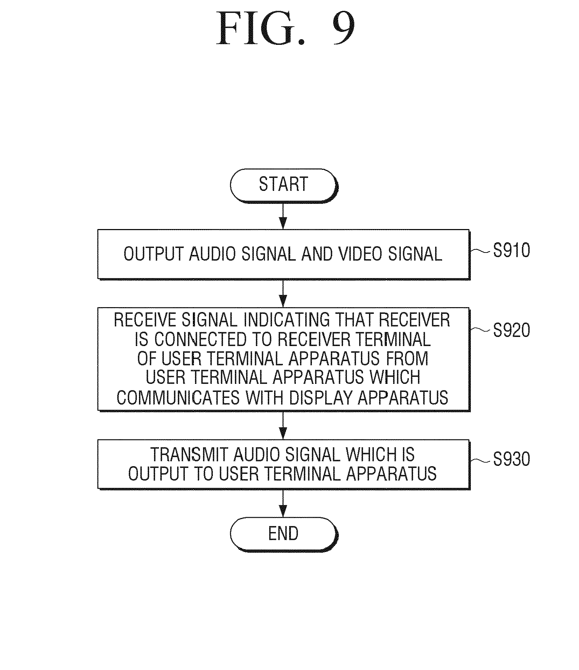

FIG. 9 is a flowchart illustrating a control method of a display apparatus according to an exemplary embodiment.

First of all, an audio signal and a video signal are output (S910). Subsequently, a signal indicating that a receiver is connected to a receiver terminal of a user terminal apparatus is received (S920). Subsequently, an audio signal which is output is transmitted to the user terminal apparatus (S930). In this case, the output of a speaker of the display apparatus may be turned off or adjusted to a predetermined volume. If a signal indicating that the receiver is disconnected from the user terminal apparatus is received, the output of the speaker may be turned on again or adjusted to a volume which was set prior to the receiver being connected.

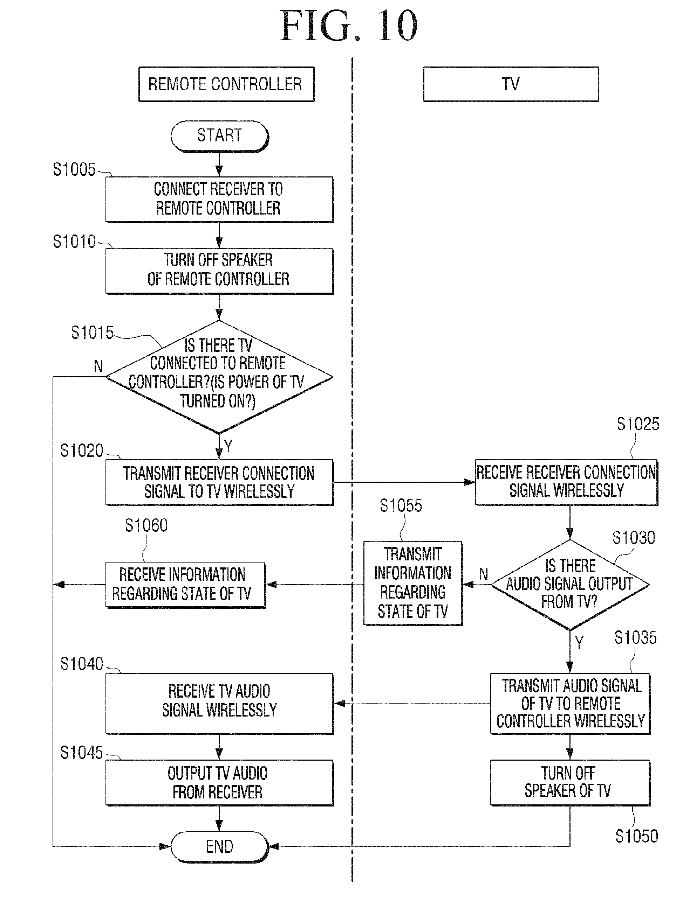

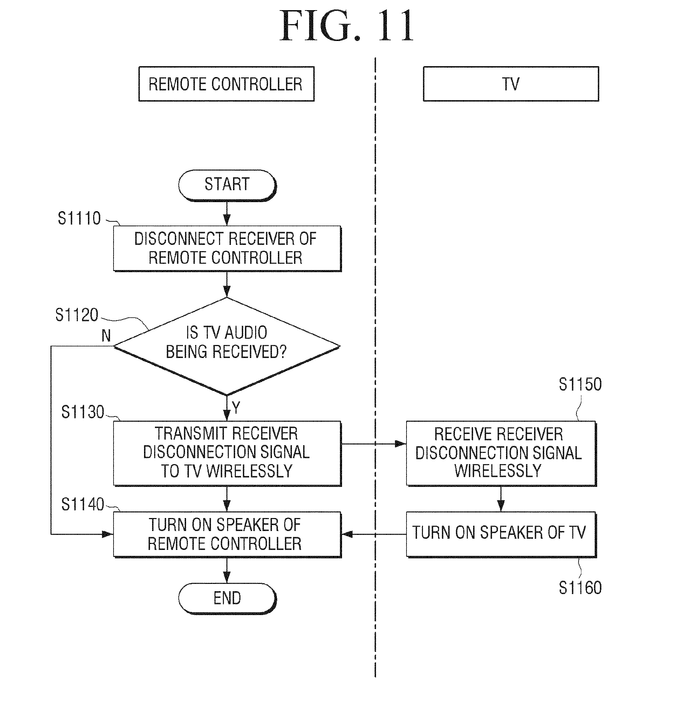

FIG. 10 is a flowchart illustrating a control method of a display system according to an exemplary embodiment. Hereinafter, an example in which a user terminal apparatus is realized as a remote controller will be described with reference to FIGS. 10 and 11.

First of all, if a receiver is connected to the remote controller (S1005), the output of a speaker of the remote controller is turned off (S1010). Subsequently, whether there is a TV interlocked with the remote controller is determined (S1015), which may include the process of determining whether the power of an interlocked TV is turned on or not. If a TV connected to the remote controller is searched (S1015:Y), a receiver connection signal is transmitted to the corresponding TV (S1020). If no TV connected to the remote controller is searched (S1015:N), no operation is performed. If the interlocked TV receives the receiver connection signal (S1025), whether there is an audio signal which is currently output from the TV is determined (S1030). If there is an audio signal output from the TV (S1030:Y), the audio signal output from the TV is transmitted to the remote controller wirelessly (S1035). In this case, the TV turns off the output of a speaker of the TV (S1050). If the remote controller receives the audio signal (S1040), the received audio signal is output through a receiver terminal (S1045). If no audio signal is output from the TV (S1030:N), information regarding the state of the TV including the information that no audio signal is output from the TV is transmitted to the remote controller (S1055). Once the remote controller receives the information regarding the state of the TV (S1060), no operation is performed.

FIG. 11 is a flowchart illustrating a control method of a display system according to another exemplary embodiment.

If a receiver connected to a remote controller is disconnected (S1110), whether an audio signal output from a TV is being received is determined (S1120). If no TV audio signal is being received (S1120:N), the output of a speaker of a remote controller is turned on (S1140). If an audio signal is being received (S1120:Y), a receiver disconnection signal indicating that the receiver is disconnected is transmitted to the TV (S1130). Once the TV receives the disconnection signal (S1150), the output of a speaker of the TV may be turned on (S1160), and the output of the speaker of the remote controller may be turned on (S1140).

As describe above, according to one or more exemplary embodiments, an audio output from a display apparatus may be controlled through an operation of connecting or disconnecting a receiver to or from a user terminal apparatus, thereby improving user convenience.

The control method according to exemplary embodiments may be realized as a program and provided in a user terminal apparatus or a display apparatus.

For example, there may be provided a non-transitory computer readable medium storing a program which performs the steps of communicating with a display apparatus outputting an audio signal and a video signal, in response to a receiver being connected to a receiver terminal of a user terminal apparatus, transmitting a signal indicating that the receiver is connected, to the display apparatus, receiving an audio signal output from the display apparatus, and outputting the received audio signal to the receiver terminal.

The non-transitory recordable medium may refer to a medium which may store data semi-permanently rather than storing data for a short time such as a register, a cache, and a memory and may be readable by an apparatus. Specifically, the above-described various applications or programs may be stored in the non-transitory readable medium may be CD, DVD, hard disk, Blu-ray disk, USB, memory card, ROM, etc. and provided therein.

The foregoing exemplary embodiments and advantages are merely exemplary and are not to be construed as limiting the disclosure. The present teaching can be readily applied to other types of apparatuses and methods. Also, the description of exemplary embodiments is intended to be illustrative, and not to limit the scope of the claims, and many alternatives, modifications, and variations will be apparent to those skilled in the art.

## Claims

1. A control method of a user terminal apparatus, comprising:
performing communication with a display apparatus which outputs an audio signal and a video signal;
in response to a receiver being connected to a receiver terminal of the user terminal apparatus, transmitting a signal indicating that the receiver is connected, to the display apparatus; and
receiving an audio signal output from the display apparatus and outputting the received audio signal to the receiver terminal.

2. The method as claimed in claim 1, wherein the outputting the audio signal comprises, in response to the audio signal being received, transmitting a signal for turning off an output of a speaker of the display apparatus to the display apparatus.

3. The method as claimed in claim 2, further comprising:
in response to the receiver being separated from the receiver terminal, transmitting a signal for turning on an output of a speaker of the display apparatus to the display apparatus.

4. The method as claimed in any one of claims 1 to 3, wherein the outputting the audio signal comprises transmitting a signal for controlling a volume of the display apparatus to a predetermined volume to the display apparatus.

5. The method as claimed in claim 4, further comprising:
in response to the receiver being separated from the receiver terminal, transmitting a signal for controlling a volume of the display apparatus to a volume which was set prior to connecting to the display apparatus, to the display apparatus.

6. The method as claimed in any one of claims 1 to 5, wherein the receiver includes at least one of an earphone and a headphone.

7. A user terminal apparatus, comprising:
a communicator configured to perform communication with a display apparatus which outputs an audio signal and a video signal;
an audio output unit configured to include a receiver terminal; and
a controller configured to, in response to a receiver being connected to a receiver terminal of the user terminal apparatus, control to transmit a signal indicating that the receiver is connected, to the display apparatus and in response to the output audio signal being received from the display apparatus, control to output the received audio signal to the receiver terminal.

8. The user terminal apparatus as claimed in claim 7, wherein the controller, in response to the audio signal being received, is arranged to control to transmit a signal for turning off an output of a speaker of the display apparatus to the display apparatus.

9. The user terminal apparatus as claimed in claim 8, wherein the controller, in response to the receiver being separated from the receiver terminal, is arranged to control to transmit a signal for turning on an output of a speaker of the display apparatus to the display apparatus.

10. The user terminal apparatus as claimed in any one of claims 7 to 9, wherein the controller is arranged to controls to transmit a signal for controlling a volume of the display apparatus to a predetermined volume to the display apparatus.

11. The user terminal apparatus as claimed in claim 10, wherein the controller, in response to the receiver being separated from the receiver terminal, is arranged to control to transmit a signal for controlling a volume of the display apparatus to a volume which was set prior to connecting the receiver to the display apparatus, to the display apparatus.

12. A display apparatus, comprising:
an output unit configured to output an audio signal and a video signal;
a communicator configured to perform communication with a user terminal apparatus; and
a controller configured to, in response to a signal indicating that a receiver is connected to a receiver terminal of the user terminal apparatus being received from the user terminal apparatus, control to transmit the output audio signal to the user terminal apparatus.

13. The apparatus as claimed in claim 12, wherein the controller is arranged to transmit the output audio signal to the user terminal apparatus and turns off an output of a speaker.

14. A control method of a display apparatus, comprising:
outputting an audio signal and a video signal;
receiving a signal indicating that a receiver is connected to a receiver terminal of a user terminal apparatus from the user terminal apparatus which performs communication with the display apparatus; and
transmitting the output audio signal to the user terminal apparatus.

15. A display system, comprising:
a display apparatus configured to output an audio signal and a video signal; and
a user terminal apparatus configured to, in response to a receiver being connected to a receiver terminal of a user terminal apparatus, transmits a signal indicating that the receiver is connected, to the display apparatus, and in response to the output audio signal being received from the display apparatus, outputs the received audio signal through the receiver terminal,
wherein the display apparatus, in response to a signal indicating that a receiver is connected to a receiver terminal of the user terminal apparatus being received, is arranged to transmit the output audio signal to the user terminal apparatus.
